# FASCICULE DE BREVET EUROPEEN

(11) **EP 3 631 481 B1**
(45) Date de publication et mention de la délivrance du brevet: **26.04.2023**
(21) Numéro de dépôt: 18724253.2
(22) Date de dépôt: 17.05.2018
(51) Int. Cl.: G01R 31/11, G01R 31/68, G01R 1/04

(54) **SYSTÈME DE RÉFLECTOMÉTRIE POUR LA DÉTECTION DE DÉFAUTS SUR UN CONNECTEUR MULTIPOINTS DURCI D'UN RÉSEAU ÉLECTRIQUE**
REFLEKTOMETRIESYSTEM ZUR FEHLERERKENNUNG AN EINER GEHÄRTETEN MEHRPUNKTSTECKVERBINDUNG EINES ELEKTRISCHEN NETZWERKS
REFLECTOMETRY SYSTEM FOR DETECTING FAULTS ON A HARDENED MULTIPOINT CONNECTOR OF AN ELECTRICAL NETWORK

(30) Priorité: 29.05.2017 FR 1700557
(43) Date de publication de la demande: 08.04.2020
(73) Titulaire: Naval Group, 75015 Paris (FR)
(72) Inventeur: TOQUET, Nicolas, 50100 Cherbourg-en-Cotentin (FR); KERAUDREN, Philippe, 50100 Cherbourg-en-Cotentin (FR)
(74) Mandataire: Lavoix
(86) Numéro de dépôt international: PCT/EP2018/063008
(87) Numéro de publication internationale: WO 2018/219682

(56) Documents cités:
- US-A- 4 325 022
- US-A- 5 268 644
- US-A1- 2007 085 550
- LOETE F ET AL: "Diagnostic of Connector's Degradation Level by Frequency Domain Reflectometry", ELECTRICAL CONTACTS (HOLM), 2012 IEEE 58TH HOLM CONFERENCE ON, IEEE, 23 septembre 2012 (2012-09-23), pages 1-4, XP032257418, DOI: 10.1109/HOLM.2012.6336591 ISBN: 978-1-4673-0778-9

## Description

La présente invention concerne un système de réflectométrie pour la détection de défauts sur un connecteur.

Plus particulièrement, l'invention se rapporte à un tel système de réflectométrie adapté pour détecter des défauts sur un connecteur multipoints durci d'un réseau électrique.

De façon générale, un tel système de réflectométrie comporte, par exemple, une sonde de mesure, associée à un oscilloscope, et permettant de détecter des défauts électriques au sein de systèmes complexes et d'environnements sévères.

De tels systèmes se rencontrent, par exemple, dans des systèmes de sousmarins, de fusées ou encore de véhicules spatiaux.

En effet, au sein de ces systèmes, il peut être impossible de démonter certains éléments électriques afin d'en vérifier l'intégrité électrique car les contrôles électriques standards, par exemple par résistance de ligne et de contact, par mesure d'isolement, ou encore par mesure de rigidité diélectrique, ne sont pas suffisants pour détecter les défauts, du fait de la conception complexe des connexions électriques (faible taille, matériaux spéciaux, design optimisé, forte densité de contacts).

Dans ces cas, le seul contrôle non destructif envisageable est une mesure spécifique de réflectométrie de la ligne électrique.

Cette technique de détection est bien connue dans l'état de la technique et est généralement utilisée pour détecter des défauts francs sur de grandes longueurs de câbles, où la précision n'est pas forcément une exigence (par exemple de l'ordre du mètre).

Un tel système de détection de défauts par réflectométrie est décrit par exemple dans la demande de brevet US5268644A.

Dans le cas de connecteurs à environnement sévère, la précision est de l'ordre du millimètre et la fréquence de la réflectométrie doit être augmentée (hyperfréquence).

Ainsi, la connexion du réflectomètre sur le connecteur doit être optimisée afin de garantir la qualité du signal et la reproductibilité des mesures.

Or, dans l'état de la technique, ceci est difficile à réaliser.

Le but de l'invention est donc de résoudre ces problèmes.

A cet effet, l'invention a pour objet un système de réflectométrie pour la détection de défauts sur un connecteur multipoints durci d'un réseau électrique, ledit système de réflectométrie comportant une sonde de mesure, caractérisé en ce qu'il comporte une pièce d'interfaçage et d'adaptation d'impédance adaptée électriquement pour être montée sur le connecteur à tester et comportant un corps muni d'au moins un organe en forme de bague de collection des masses des contacts du connecteur, le corps (13) et l'organe (14) en forme de bague de collection des masses des contacts du connecteur comportant un orifice de mesure pour la sonde du système de réflectométrie.

Suivent d'autres caractéristiques du système de réflectométrie selon l'invention, prises seules ou en combinaison :
- l'organe en forme de bague de collection des masses est associé à des moyens de réception et de positionnement de la sonde de mesure en regard d'un contact du connecteur à tester,
- l'organe en forme de bague de collection des masses est associé à des contacts électriques à ressort pour conserver l'endurance fonctionnelle du connecteur,
- l'organe en forme de bague de collection des masses des contacts est associé de façon amovible au corps de la pièce d'interfaçage, de façon à pouvoir être remplacé par un autre organe en forme de bague de collection des masses interchangeable présentant un orifice de mesure d'accès à un contact différent du connecteur pour le tester,
- l'organe en forme de bague de collection des masses des contacts est associé de façon démontable au corps de la pièce d'interfaçage, de façon à pouvoir être déplacé et remonté sur celui-ci, afin que son orifice de mesure donne accès à des contacts différents du connecteur pour les tester,
- la sonde de mesure est raccordée à un oscilloscope.

L'invention sera mieux comprise à la lecture de la description qui va suivre, donnée uniquement à titre d'exemple et faite en se référant aux dessins annexés, sur lesquels :
- la figure 1 représente une vue en coupe schématique d'un système de réflectométrie de l'état de la technique ;
- la figure 2 représente une vue en coupe schématique d'un système de réflectométrie selon l'invention;
- la figure 3 représente une vue en bout d'une pièce d'interfaçage et d'adaptation d'impédance entrant dans la constitution d'un système selon l'invention ; et
- la figure 4 illustre un contact électrique à ressort utilisé dans un système selon l'invention.

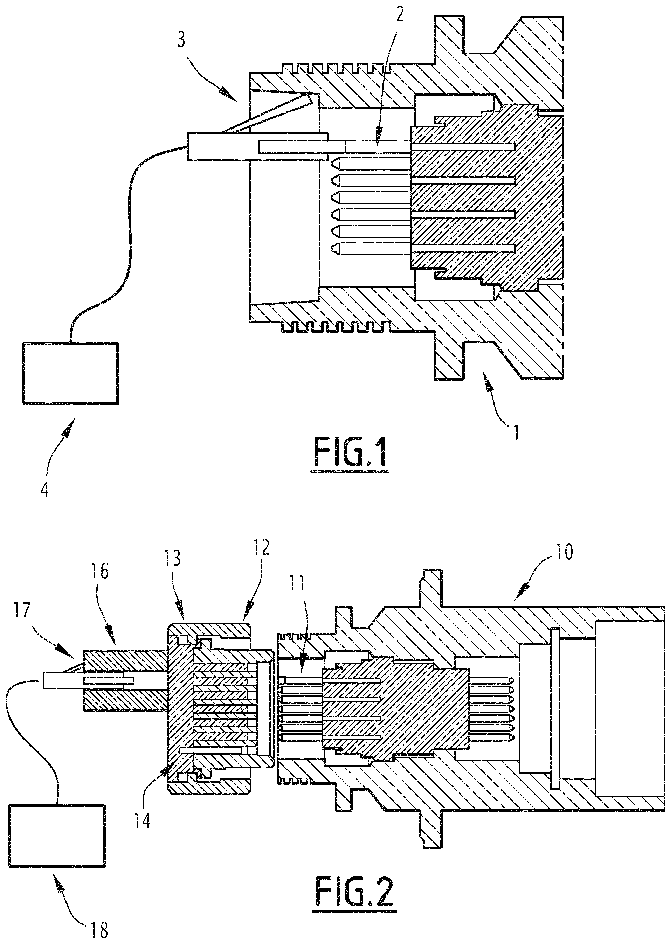

On a en effet illustré sur ces figures et en particulier sur la figure 1, un système de réflectométrie de l'état de la technique.

Ce système est utilisé pour la détection de défauts sur un connecteur multipoints durci d'un réseau électrique.

Ce connecteur est désigné par la référence générale 1 sur cette figure 1, et celui-ci comporte plusieurs contacts électriques, tels que le contact désigné par la référence générale 2 suivant cette même figure.

Le système de réflectométrie comporte également une sonde de mesure, désignée par la référence générale 3, associée à un oscilloscope, désigné par la référence générale 4.

Cette sonde est adaptée pour être placée au contact de chaque contact électrique du connecteur, afin de tester celui-ci et de détecter éventuellement un défaut du réseau correspondant.

Comme cela a été indiqué précédemment, cette structure présente un certain nombre d'inconvénients, notamment au niveau de la difficulté de positionner correctement la sonde et donc au niveau de la qualité et de la reproductibilité de la mesure correspondante.

Pour résoudre ces problèmes, on utilise, dans un système de réflectométrie selon l'invention, une pièce d'interfaçage et d'adaptation d'impédance comportant une bague de collection des masses et un orifice de mesure pour la sonde.

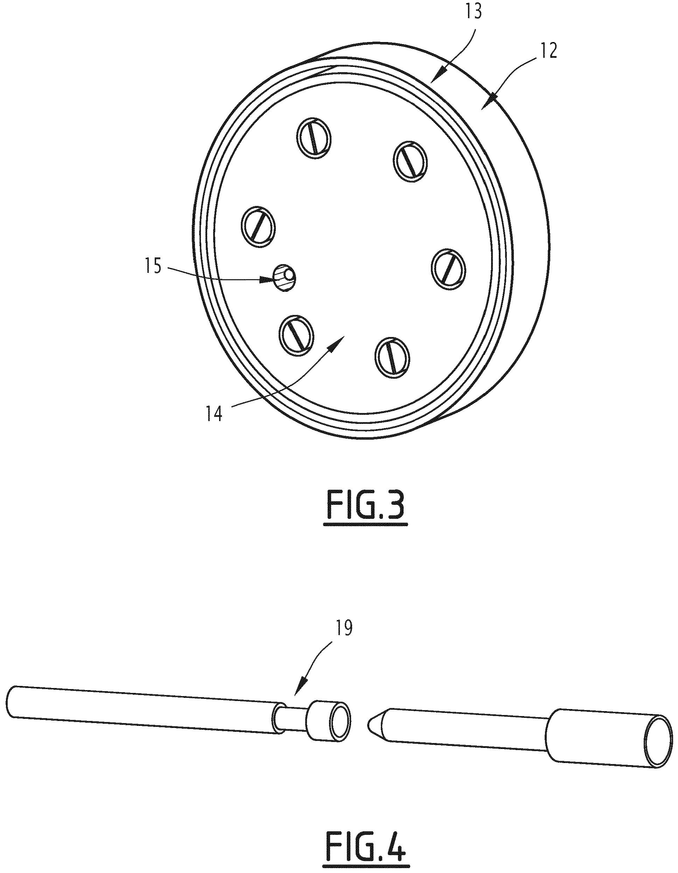

On a représenté un exemple de réalisation d'un tel système sur les figures 2 et 3.

Sur ces figures, le connecteur multipoints durci du réseau électrique est désigné par la référence générale 10, et celui-ci comporte toujours des contacts, tels que le contact désigné par la référence générale 11.

Le système selon l'invention comporte une pièce d'interfaçage et d'adaptation d'impédance conçue pour être montée sur le connecteur à tester, cette pièce d'interfaçage et d'adaptation d'impédance étant désignée par la référence générale 12.

Cette pièce d'interfaçage et d'adaptation d'impédance est adaptée pour être montée sur le connecteur à tester 10.

Cette pièce comporte un corps désigné par la référence générale 13 sur ces figures, ce corps étant muni d'au moins un organe en forme de bague de collection des masses des contacts du connecteur, cette bague étant désignée par la référence générale 14.

Le corps et la bague comportent également un orifice de mesure pour permettre l'introduction de la sonde du système de réflectométrie, cet orifice étant désigné, par exemple, par la référence générale 15 sur la figure 3.

En fait, et comme cela est illustré sur la figure 2, l'organe en forme de bague de collection des masses est également associé à des moyens de réception et de positionnement de la sonde de mesure en regard d'un contact du connecteur à tester.

Sur la figure 2, ces moyens de réception et de positionnement de la sonde sont désignés par la référence générale 16 et la sonde est désignée par la référence générale 17.

De façon classique, celle-ci est toujours raccordée à un oscilloscope, désigné par la référence générale 18.

Comme cela est également illustré sur ces figures et en particulier sur la figure 2, l'organe 14 en forme de bague de collection des masses des contacts est associé de façon amovible au corps 13 de la pièce d'interfaçage.

Ceci permet alors, par exemple, de remplacer cet organe par un autre organe interchangeable en forme de bague de collection des masses, présentant un orifice de mesure d'accès à un contact différent du connecteur pour le tester.

Bien entendu, d'autres modes de réalisation peuvent être envisagés et, par exemple, l'organe en forme de bague de collection des masses des contacts peut également être associé de façon démontable au corps de la pièce d'interfaçage, de façon à pouvoir être déplacé et remonté sur celui-ci afin que son orifice de mesure donne accès à des contacts différents du connecteur pour les tester.

Enfin, et comme cela est illustré sur la figure 4, il est à noter que l'organe en forme de bague de collection des masses peut être associé à des contacts électriques à ressort, tels que celui désigné par la référence générale 19 sur cette figure 4, pour conserver l'endurance fonctionnelle du connecteur.

On conçoit alors qu'une telle structure présente un certain nombre d'avantages par rapport aux systèmes de l'état de la technique.

En effet, l'utilisation de la pièce d'interfaçage, telle que décrite précédemment, permet d'améliorer la qualité du contact et donc la qualité de la mesure et la reproductibilité de celle-ci, tout en étant d'une plus grande facilité de mise en oeuvre.

Bien entendu, d'autres modes de réalisation encore peuvent être envisagés.

## Revendications

1. Système de réflectométrie pour la détection de défauts sur un connecteur multipoints durci (10) d'un réseau électrique, ledit système de réflectométrie comportant une sonde de mesure (17), **caractérisé en ce qu'**il comporte une pièce d'interfaçage et d'adaptation d'impédance (12) adaptée électriquement pour être montée sur le connecteur à tester et comportant un corps (13) muni d'au moins un organe (14) en forme de bague de collection des masses des contacts du connecteur, le corps (13) et l'organe (14) en forme de bague de collection des masses des contacts du connecteur comportant un orifice de mesure (15) pour la sonde du système de réflectométrie.

2. Système de réflectométrie selon la revendication 1, **caractérisé en ce que** l'organe (14) en forme de bague de collection des masses est associé à des moyens (16) de réception et de positionnement de la sonde de mesure en regard d'un contact (11) du connecteur à tester.

3. Système de réflectométrie selon la revendication 1 ou 2, **caractérisé en ce que** l'organe (14) en forme de bague de collection des masses est associé à des contacts électriques à ressort (19) pour conserver l'endurance fonctionnelle du connecteur (10).

4. Système de réflectométrie selon l'une quelconque des revendications précédentes, **caractérisé en ce que** l'organe (14) en forme de bague de collection des masses des contacts est associé de façon amovible au corps (13) de la pièce d'interfaçage (12), de façon à pouvoir être remplacé par un autre organe en forme de bague de collection des masses interchangeable présentant un orifice de mesure d'accès à un contact différent du connecteur pour le tester.

5. Système de réflectométrie selon l'une quelconque des revendications 1 à 3, **caractérisé en ce que** l'organe (14) en forme de bague de collection des masses des contacts est associé de façon démontable au corps (13) de la pièce d'interfaçage (12), de façon à pouvoir être déplacé et remonté sur celui-ci, afin que son orifice (15) de mesure donne accès à des contacts différents du connecteur pour les tester.

6. Système de réflectométrie selon l'une quelconque des revendications précédentes, **caractérisé en ce qu'**il comprend en outre un oscilloscope (18) et que la sonde de mesure (17) est raccordée à cet oscilloscope (18).

## Patentansprüche

1. Reflektometriesystem zur Erkennung von Fehlern an einem gehärteten Mehrpunktverbinder (10) eines elektrischen Netzwerks, das Reflektometriesystem umfassend eine Messsonde (17), **dadurch gekennzeichnet, dass** es ein Schnittstellen- und Impedanzanpassungsteil (12) umfasst, das elektrisch angepasst ist, um auf dem zu prüfenden Verbinder montiert zu werden, und umfassend einen Körper (13), der mit mindestens einem Element (14) in Form eines Massensammelrings der Kontakte des Verbinders versehen ist, der Körper (13) und das Element (14) in Form eines Massensammelrings der Kontakte des Verbinders umfassend eine Messöffnung (15) für die Sonde des Reflektometriesystems.

2. Reflektometriesystem nach Anspruch 1, **dadurch gekennzeichnet, dass** das Element (14) in Form eines Massensammelrings mit Einrichtungen (16) zur Aufnahme und Positionierung der Messsonde gegenüber einem Kontakt (11) des zu prüfenden Verbinders verbunden ist.

3. Reflektometriesystem nach Anspruch 1 oder 2, **dadurch gekennzeichnet, dass** das Element (14) in Form eines Massensammelrings mit federbelasteten elektrischen Kontakten (19) verbunden ist, um die Funktionsausdauer des Verbinders (10) beizubehalten.

4. Reflektometriesystem nach einem der vorherigen Ansprüche, **dadurch gekennzeichnet, dass** das Element (14) in Form eines Massensammelrings der Kontakte lösbar mit dem Körper (13) des Schnittstellenteils (12) verbunden ist, sodass es durch ein anderes austauschbares Element in Form eines Massensammelrings ersetzt werden kann, das eine Messöffnung für den Zugang zu einem anderen Kontakt als dem Verbinder aufweist, um diesen zu prüfen.

5. Reflektometriesystem nach einem der Ansprüche 1 bis 3, **dadurch gekennzeichnet, dass** das Element (14) in Form eines Massensammelrings der Kontakte abnehmbar mit dem Körper (13) des Schnittstellenteils (12) verbunden ist, sodass es darauf verschoben und wieder montiert werden kann, damit seine Messöffnung (15) Zugang zu verschiedenen Kontakten des Verbinders bietet, um sie zu prüfen.

6. Reflektometriesystem nach einem der vorherigen Ansprüche, **dadurch gekennzeichnet, dass** es ferner ein Oszilloskop (18) umfasst und dass die Messsonde (17) an dieses Oszilloskop (18) angeschlossen ist.

## Claims

1. A reflectometry system for detecting faults on a hardened multipoint connector (10) of an electrical network, said reflectometry system comprising a measuring probe (17), **characterized in that** it comprises an interfacing and impedance matching part (12) that is electrically suitable for mounting on the connector to be tested and comprises a body (13) provided with at least one element (14) in the form of a collector ring for the contact masses of the connector, the body (13) and the element (14) in the form of a collector ring for the contact masses of the connector comprising a measuring opening (15) for the probe of the reflectometry system.

2. The reflectometry system according to claim 1, **characterized in that** the element (14) in the form of a collector ring for the masses is associated with means (16) for receiving and positioning the measuring probe across from a contact (11) of the connector to be tested.

3. The reflectometry system according to claim 1 or 2, **characterized in that** the element (14) in the form of a collector ring for the masses is associated with electrical spring contacts (19) to preserve the functional endurance of the connector (10).

4. The reflectometry system according to any one of the preceding claims, **characterized in that** the element (14) in the form of a collector ring for the contact masses is removably associated with the body (13) of the interfacing part (12), so as to be able to be replaced by another element in the form of an interchangeable collector ring for the masses having an opening for measuring access to a contact different from the connector in order to test it.

5. The reflectometry system according to any one of claims 1 to 3, **characterized in that** the element (14) in the form of a collector ring for the contact masses is separately associated with the body (13) of the interfacing part (12), so as to be able to be moved and reassembled thereupon, so that its measuring opening (15) provides access to different contacts of the connector in order to test them.

6. The reflectometry system according to any one of the preceding claims, **characterized in that** it further comprises an oscilloscope (18) and that the measuring probe (17) is connected to this oscilloscope (18).
